# EUROPÄISCHE PATENTSCHRIFT

(11) **EP 0 387 730 B1**
(45) Veröffentlichungstag und Bekanntmachung des Hinweises auf die Patenterteilung: **19.04.1995**
(21) Anmeldenummer: 90104585.6
(22) Anmeldetag: 10.03.1990
(51) Int. Cl.: H02H 9/04, H01H 47/32

(54) **Elektronische Schützschnellabschaltung**
Electronic contactor with emergency shut-down
Contacteur électronique avec arrêt d'urgence

(30) Priorität: 13.03.1989 DE 3908055
(43) Veröffentlichungstag der Anmeldung: 19.09.1990
(73) Patentinhaber: Licentia Patent-Verwaltungs-GmbH, 60596 Frankfurt (DE)
(72) Erfinder: Meyer, Herbert, Dr., D-2350 Neumünster (DE); Balow, Thomas, D-2351 Brokstedt (DE); Giday, Zoltan, D-2350 Neumünster (DE)
(74) Vertreter: Vogl, Leo, Dipl.-Ing.

(56) Entgegenhaltungen:
- EP-A- 0 298 737
- GB-A- 2 095 065
- ELEKTRONIK, Band 36, Nr. 23, 13. November 1987, Seiten 142-152, München, DE ; H. SAX : "Verlustarme Ansteuerung von Aktuatoren"

## Beschreibung

Die Erfindung betrifft eine elektronische Schützschnellabschaltung gemäss dem Oberbegriff des Anspruchs 1. Eine solche Schaltung ist aus der GB-A-2 095 065 bekannt.

Wenn ein Gleichstromschütz mit Freilaufkreis abgeschaltet wird, dann hält es sich für eine Zeit von ca. 70 ms selbst und öffnet erst dann seine Kontakte. Zur Beschleunigung der Abschaltung sind Freilaufkreise mit Zenerdioden bekannt geworden (vgl. z. B. DE-AS 11 49 810), wobei im Falle der DE-OS 36 09 629 die Zenerdiode in den Transistor integriert ist. Diese Lösungen befriedigen jedoch häufig nicht. Um eine Schnellabschaltung zu erlangen, die in einem Bruchteil der vorgenannten Zeitspanne erfolgt, muss der Freilaufstrom unterbunden und dafür gesort werden, dass sich die Lastinduktivität entladen kann. Dafür geeignete Schaltungsanordnungen sind z. B. aus der Fachzeitschrift "Elektronik", 23/13.11.87/Seite 143 und 144, bekannt. In diesen Verfahren wird der Freilaufkreis mit einem standardmässigen Schalttransistor T1 abgeschaltet und die Abschaltenergie der Schützspule entweder über Dioden in die Versorgung zurückgespeist (Bild 5, S. 144) oder über eine Zenerdiode in Wärme umgesetzt (Bild 7, S. 144).

Der Erfindung liegt die Aufgabe zugrunde, eine Schützschnellabschaltung zu schaffen, die auch bei abgeschalteter Masse die Abschaltenergie abbaut und die beim Abschalten entstehenden Spannungsspitzen verringert.

Diese Aufgabe wird erfindungsgemäß durch die im Kennzeichen des Anspruchs 1 angegebenen Merkmale gelöst.

Die Erfindung hat den Vorteil, daß für die Taktung des Spulenstromes preiswerte Halbleiterbauelemente mit geringen Sperrspannungen eingesetzt werden können, da gegenüber der Verwendung einer Zenerdiode, die in der Schaltung durch einen Vorwiderstand geschützt sein muß, wesentlich geringere Abschaltspannungsspitzen auftreten. Die Transient-Spannungsunterdrückungsdiode kann hohe Stoßströme aufnehmen, benötigt deshalb keinen Vorwiderstand, und schaltet schneller durch als eine Zener-Diode. Auch das schnelle Durchschalten trägt dazu bei, daß sich keine hohen Spannungsspitzen in der Schaltung aufbauen. Mit der Auswahl der Durchlaßspannung der Transient-Spannungsunterdrückungsdiode kann die Abschaltzeit beliebig beeinflußt werden, in dem Rahmen, in dem die Sperrspannungen der überbrückten Halbleiterbauelemente nicht überschritten werden. Mit der Rückkopplungsdiode zwischen dem Masseanschluß der Transient-Spannungsunterdrückungsdiode und dem Spuleneingang wird auf einfache Weise die Entladung der Lastinduktivität bei abgeschalteter Masse ermöglicht.

Anhand der Zeichnung wird ein Ausführungsbeispiel der Erfindung näher erläutert.

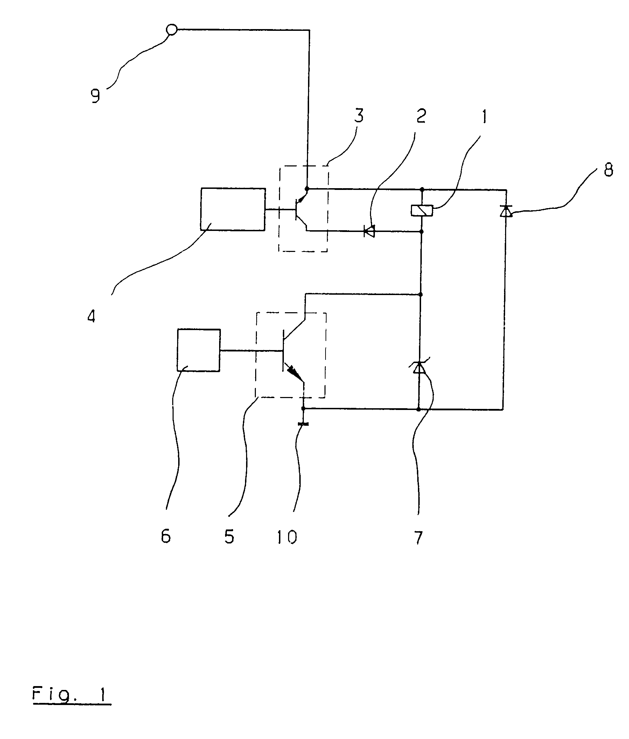

Das in Fig. 1 dargestellte Schaltbild zeigt eine elektronische Schützabschaltung mit einem Leistungstransistor 5 der zum Zwecke der Stromregelung den Strom durch die Schützspule 1 taktet, wozu er in einer hier nicht näher erläuterten, Taktregelung 6 eingebunden ist. Damit in den Ausschaltphasen der Stromtaktung das Schütz nicht abfällt, ist die Schützspule 1 in bekannter Weise mit einem Freilaufkreis beschaltet, in dem sich eine Freilaufdiode 2 und ein Schalttransistor 3 befindet, der über eine Steuerung 4 den Freilaufkreis zum Zwecke er Schützschnellabschaltung abschalten kann. Die beim Abschalten des Last- und des Freilaufkreises entstehende Spannungsspitze wird über eine Transient-Spannungsunterdrückungsdiode 7 begrenzt und die in der Schützspule enthaltene Energie durch den über die Transient-Spannungsunterdrückungsdiode 7 fließenden Strom in Wärme umgewandelt. Der Strom fließt entweder zur Masse 10 oder bei abgeschalteter Masse 10 über eine Rückkopplungsdiode 8 in die Schützspule zurück.

Als Transient-Spannungsunterdrückungsdiode 7 kann eine TransZorb - Diode der Firma Semiconductor Industries, Inc., Square D Compony, verwendet werden, die z. Bsp. im "Data-Book 1983" dieser Firma beschrieben ist. Gegenüber herkömmlichen Zenerdioden besitzen diese TransZorb-Dioden den Vorteil einer hohen Stoßstromfestigkeit und extrem schneller Durchschaltzeiten (Pikosekundenbereich).

Die Transient-Spannungsunterdrückungsdiode 7 ist parallel zum Leistungstransistor 5 geschaltet, um den Transistor 5 vor der beim Abschalten entstehenden induzierten Spannung zu schützen. Dabei muß die Diode 7 fast die gesamte Spulenenergie aufnehmen. Mit der Auswahl der Durchbruchspannung der Diode 7 kann die Abschaltzeit des Schützes beeinflußt werden. Mit einer Verkürzung der Abschaltzeit steigt die von der Diode 7 aufzunehmende Leistung bis zu Spitzenleistungen, die, bei Einstellung extrem kurzer Abschaltzeiten, im Kilowattbereich liegen.

## Patentansprüche

1. Elektronische Schützschnellabschaltung mit einem abschaltbaren Freilaufkreis (2, 3) und einem Halbleiterbauelement (7) mit definierter Durchbruchsspannung zur Begrenzung der induktiven Spannungsspitzen beim Abschalten des Last- und des Freilaufkreises, wobei das Halbleiterbauelement (7) parallel zu einem elektronischen Schaltglied (5) geschaltet ist, mit dem der Strom durch die Schützspule (1) zwecks Stromregelung getaktet wird, **dadurch gekennzeichnet**, daß das Halbleiterbauelement (7) eine Transient-Spannungsunterdrückungsdiode (7) ist, und daß eine Rückkopplungsdiode (8) in Durchlaßrichtung zwischen dem masseseitigen Anschluß der Spannungsunterdrückungsdiode (7) und dem Eingang der Schützspule (1) geschaltet ist, die bei abgeschalteter Masse (10) einen Abbau der Abschalt-Spannungsspitze über einen Rückstrom durch die Schützspule (1) gewährleistet.

2. Elektronische Schützschnellabschaltung nach Anspruch 1, **dadurch gekennzeichnet,** daß die Transient-Spannungsunterdrückungsdiode (7) aus einer Transzorb-Diode besteht.

## Claims

1. Electronic protective quick-action circuitbreaker with a freewheel circuit (2, 3) which can be switched off and a semiconductor component (7) with a defined breakdown voltage for limitation of inductive voltage peaks on switching off of the load circuit and the freewheel circuit, wherein the semiconductor component (7) is connected in parallel with an electronic switching element (5) which is pulsed by the current through the protective coil (1) for the purpose of current regulation, characterised thereby that the semiconductor component (7) is a transient voltage suppression diode (7) and that a feedback diode (8) is connected in conducting direction between the terminal, which is at ground side, of the voltage suppression diode (7) and the input of the protective coil (1) and ensures a decay of the switching-off voltage peak by way of a return current through the protective coil (1) when ground (10) is disconnected.

2. Electronic protective quick-action circuitbreaker according to claim 1, characterised thereby that the transient voltage suppression diode (7) consists of a TransZorb diode.

## Revendications

1. Disjoncteur électronique ultrarapide de protection comprenant un circuit de passage libre déconnectable (2, 3) et un composant semi-conducteur (7) à tension de claquage définie pour limiter les pics de tension inductive lors de la déconnexion du circuit de charge et de passage libre, le composant semi-conducteur (7) étant commuté en parallèle à un organe de commutation électronique (5) avec lequel, en vue de la régulation électrique, le courant est synchronisé par la bobine de protection (1), caractérisé en ce que le composant semiconducteur est une diode de suppression de tension transitoire (7), et en ce qu'une diode de rétro-action (8) est connectée dans le sens de passage entre le branchement côté masse de la diode de suppression de tension (7) et l'entrée de la bobine de protection (1) qui garantit, quand la masse (10) est déconnectée, une élimination des pics de tension de déconnexion par l'intermédiaire d'un retour de courant à travers la bobine de protection (1).

2. Disjoncteur électronique ultrarapide de protection selon la revendication 1, caractérisé en ce que la diode de suppression de tension transitoire (7) est une diode Transzorb.
